**Europäisches Patentamt**

**European Patent Office**

**Office européen des brevets**

(19)

(11) **EP 1 432 195 A1**

(12) **EUROPEAN PATENT APPLICATION**

(43) Date of publication:
   **23.06.2004  Bulletin 2004/26**

(51) Int Cl.7: **H04L 27/36**, H03C 3/40

(21) Application number: **02258665.5**

(22) Date of filing: **17.12.2002**

| | |
|---|---|
| (84) Designated Contracting States:<br>**AT BE BG CH CY CZ DE DK EE ES FI FR GB GR IE IT LI LU MC NL PT SE SI SK TR**<br>Designated Extension States:<br>**AL LT LV MK RO**<br><br>(71) Applicant: **Telefonaktiebolaget LM Ericsson (publ)**<br>**164 83 Stockholm (SE)** | (72) Inventor: **Bristow, Robert**<br>**Hants, RG22 5JJ Basingstoke (GB)**<br><br>(74) Representative: **Clarke, Alison Clare**<br>**Haseltine Lake,**<br>**Imperial House, 15-19 Kingsway**<br>**London WC2B 6UD (GB)** |

(54) **Method and apparatus for quadrature modulation**

(57)   A quadrature modulator which compensates for phase errors introduced by the quadrature oscillator is described. The principle underlying the phase error compensation is the well known fact that when two vectors of equal magnitude and arbitrary phase difference are combined to form a sum vector and a difference vector, the sum vector and the difference vector are guaranteed to differ in phase by exactly 90 degrees. Any resulting magnitude errors are taken care of by appropriately scaling I and Q signals before calculating sum and difference. The scaling factors depend on the phase error of the quadrature oscillator.

Fig. 3

**Description**

## TECHNICAL FIELD

The present invention relates to a method and apparatus for quadrature modulation.

## BACKGROUND OF THE INVENTION

In a quadrature modulator used in wireless communication systems, for example, it is desirable to modulate the magnitude and phase of the carrier signal, namely

$$V(t) := M(t).\sin(\omega t + \phi(t))$$

where $t$ is time; $\omega$ is the angular frequency of the carrier in radians per second; $M(t)$ is the time varying magnitude component of the modulation; and $\phi(t)$ is the time varying phase component of the modulation.

By performing a simple polar to Cartesian conversion on the formula above, the M and $\phi$ can be replaced by I and Q:

$$V(t) := \sqrt{I(t)^2 + Q(t)^2} . \sin\left(\omega.t + \arctan\left(\frac{Q(t)}{I(t)}\right)\right)$$

This can be simplified to

$$V(t) := \sqrt{I(t)^2 + Q(t)^2} . \left(\sin(\omega.t).\cos\left(\arctan\left(\frac{Q(t)}{I(t)}\right)\right) + \cos(\omega.t).\sin\left(\arctan\left(\frac{Q(t)}{I(t)}\right)\right)\right)$$

Since

$$\cos\left(\arctan\left(\frac{Q(t)}{I(t)}\right)\right) = \frac{I(t)}{\sqrt{I(t)^2 + Q(t)^2}}$$

and

$$\sin\left(\arctan\left(\frac{Q(t)}{I(t)}\right)\right) = \frac{Q(t)}{\sqrt{I(t)^2 + Q(t)^2}}$$

the resulting expression for the modulated carrier waveform is:

$$V(t) := I(t).\sin(\omega.t) + Q(t).\cos(\omega.t)$$

A quadrature modulator, therefore, needs to take the incoming baseband signals $I(t)$ and $Q(t)$ and perform the above operation to modulate them. However, to do this accurately in an electronic circuit, two sinewaves in precise quadrature need to be produced i.e. generate the above sin and cos terms. In conventional IQ modulators, this is achieved by an accurate quadrature local oscillator.

The outputs of the quadrature local oscillator, ideally, have a phase difference of exactly 90°. However, at high frequencies achieving and maintaining the accuracy of the 90° phase shift is not always possible and inaccuracy often occurs. This causes errors in the modulated carrier to occur. The local oscillator error can be corrected, for example, as disclosed by US 4717894, however, such modulators are generally complex in design.

Compensation of amplitude and phase errors in a received signal is disclosed by EP 0602394. The technique is to scale the baseband signals by a correction factor. This correction factor is dynamically determined from the incoming received signals. The sum and difference of the baseband signals are derived from the unscaled and scaled signals. Either the sum or difference signal is scaled by a second correction factor to make the amplitude of the sum and difference equal. However, this technique is only effective if the signals result from a constant amplitude received carrier signal. Consequently, this technique could not be applied to an arbitrary modulation format, e.g. QAM in which case the amplitude component of the modulation would be distorted.

## SUMMARY OF THE INVENTION

The object of the invention is to provide a technique and apparatus which can easily compensate for errors in the quadrature and that can be used with a conventional modulator with any modulation format. The technique of the invention is basically to compute the sum and difference of scaled I and Q signals, and these composite signals are passed to a conventional quadrature modulator, the scaling factor being derived from the phase error of the quadrature local oscillator. The end result is to give an easy way of eliminating the error caused by the sin and cos terms not being exactly 90° apart.

## BRIEF DESCRIPTION OF DRAWINGS

Figure 1 is a simplified, block diagram of the modulating means according to an embodiment of the present invention;
Figure 2 is a more detailed schematic diagram of the modulating means of Figure 1;
Figure 3 is a schematic diagram of a modulating means according to another embodiment of the present invention; and
Figure 4 is a block diagram illustrating the method according to an embodiment of the present invention.

## DETAILED DESCRIPTION OF PREFERRRED EMBODIMENTS

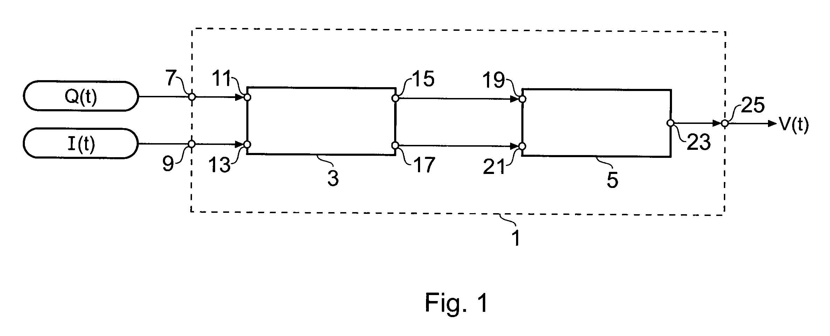

A preferred embodiment of the present invention will now be described with reference to Figure 1.

The modulating means 1 of the preferred embodiment of the present invention comprises a pre-processor 3 and modulator 5. The modulating means 1 further comprises a first input terminal 7 and a second input terminal 9. The first input terminal 7 receives the $Q(t)$ incoming baseband signal. The second input terminal 9 receives the $I(t)$ incoming baseband signal. The first input terminal 7 is connected to a first input terminal 11 of the pre-processor 3. The second input terminal 9 of the modulating means 1 is connected to a second input terminal 13 of the pre-processor 3. The pre-processor 3 comprises a first output terminal 15 and a second output terminal 17. The first output terminal 15 of the pre-processor 3 is connected to a first input terminal 19 of the quadrature modulator 5. The second output terminal 17 of the pre-processor 3 is connected to a second input terminal 21 of the modulator 5. The modulator 5 further comprises an output terminal 23 which is connected to an output terminal 25 of the modulating means 1. The output terminal 25 of the modulating means 1 outputting the modulated signal $V(t)$.

The pre-processor 3 computes the sum and difference of the I and Q signals input on the first and second input terminals 11, 13 of the pre-processor 3. The sum of the I and Q signals is output at the first output terminal 15 of the pre-processor 3 and is input into the modulator 5 at the first input terminal 19 of the modulator 5.

The difference of the I and Q signals is output at the second output terminal 17 of the pre-processor 3 to be input into the modulator 5 at the second input terminal 21 of the modulator 5.

The modulator 5 may comprise a conventional quadrature modulator and the first and second input terminals 19, 21 of the modulator 5 correspond to the input terminals of a conventional quadrature modulator which would ordinarily receive the incoming Q and I baseband signals, respectively.

The composite signal input into the modulator 5 at the first and second input terminals 19, 21 of the modulator 5 are quadrature modulated to generate the modulated signal $V(t)$ which is output on the output terminal 23 of the modulator 5 and hence the output terminal 25 of the modulating means 1.

The pre-processor 3, in computing the sum and difference of the I and Q signals and providing these on the input of a quadrature modulator 5 can effectively compensate for any phase error in the local oscillator as illustrated below.

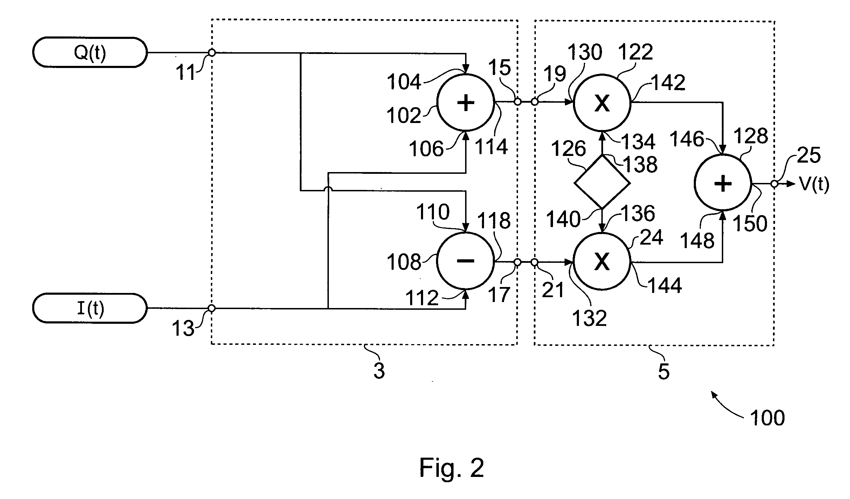

In more detail, with reference to Figure 2, the pre-processor 3 of Figure 1 comprises an adder 102 having two input terminals 104, 106. The first input terminal 104 of the adder 102 is connected to the first input terminal 11 of the pre-processor 3 which receives the incoming $Q(t)$ baseband signal. The second input terminal 106 of the adder 102 is connected to the second input terminal 13 of the pre-processor 3 which receives the incoming $I(t)$ baseband signal. The pre-processor 3 also includes a subtractor 108 having two input terminals 110, 112. The first input terminal 110 of the subtractor 108 is connected to the first input terminal 11 of the pre-processor 3. The second input terminal 112 of the subtractor 108 is connected to the second input terminal 13 of the pre-processor 3. The adder 102 has an output terminal 114 which is connected to the first output terminal 15 of the pre-processor 3. The subtractor 108 has an output terminal 118 connected to the second output terminal 17 of the pre-processor 3.

The modulator 5 comprises a pair of mixers 122, 124, a local oscillator signal generator 126 and adder 128. A first input terminal 130 of the first mixer 122 is connected to the first input terminal 19 of the modulator 5. A first input terminal 132 of the second mixer 124 is connected to the second input terminal 21 of the modulator 5. A second input terminal 134 of the first mixer 122 and a second input terminal 136 of the second mixer 124 are connected to quadrature outputs 138 and 140 of the local oscillator generator 126. An output terminal 142 of the first mixer 122 and an output terminal 144 of the second mixer 124 are connected to respective input terminals 146, 148 of the adder 128. An output terminal 150 of the adder 128 is connected to the output terminal 23 of the modulator 5.

It is assumed that the modulator 5 is not ideal. Therefore, it is assumed that instead of the cos and sin terms which should be produced on these outputs 138, 140, there exists two sin terms separated by the angle $\alpha$. In an ideal modulator having no phase error, the correct sin and cos terms would be produced on the quadrature outputs 138, 140 of the local oscillator generator 126 and in this case $\alpha$ would be 90°.

The sum and difference of the I and Q signals are applied at the first and second input terminals 19, 21 of this nonideal modulator 5, and the overall result is:

$$V(t) := (I(t) - Q(t)).\sin(\omega.t) + (I(t) + Q(t)).\sin(\omega.t + \alpha)$$

using standard trig formulae for $\sin(a) + \sin(b)$ and $\sin(a) - \sin(b)$

$$2I(t).\sin\left[\frac{\omega.t + (\omega.t + \alpha)}{2}\right].\cos\left[\frac{\omega.t + (\omega.t + \alpha)}{2}\right] + 2Q(t).\sin\left[\frac{(\omega.t + \alpha) - \omega.t}{2}\right].\cos\left[\frac{(\omega.t + \alpha) + \omega.t}{2}\right]$$

or:

$$2.I(t).\cos\left(\frac{\alpha}{2}\right).\sin\left(\omega.t + \frac{\alpha}{2}\right) + 2.Q(t).\sin\left(\frac{\alpha}{2}\right).\cos\left(\omega.t + \frac{\alpha}{2}\right)$$

Therefore, replacing the I and Q signals with I+Q and I-Q produces the effect of ideal quadrature in the carrier sinewaves, since they appear in the form of sin and cos functions with the same angle argument.

However, the magnitude has increased by a factor of 2 and the absolute phase has moved forward by $\pi/_4$. These changes are not usually important in a wireless application since the absolute phase of the carrier is of no importance, and the amplitude is usually controlled by other means.

The I and Q waves are scaled by small amounts related to the phase error of the original modulator. To confirm that the formula is correct $\alpha$ is set to 90° ($\pi/_2$ radians), then:

$$2.I(t).\cos\left(\frac{1}{2}.\frac{\pi}{2}\right).\sin\left(\omega.t + \frac{1}{2}.\frac{\pi}{2}\right) + 2.Q(t).\sin\left(\frac{1}{2}.\frac{\pi}{2}\right).\cos\left(\omega.t + \frac{1}{2}.\frac{\pi}{2}\right)$$

now:

$$\sin\left(\frac{\pi}{4}\right) = \cos\left(\frac{\pi}{4}\right) = \frac{\sqrt{2}}{2}$$

resulting in:

$$I(t).\sqrt{2}.\sin\left(\omega.t + \frac{\pi}{4}\right) + Q(t).\sqrt{2}.\cos\left(\omega.t + \frac{\pi}{4}\right)$$

This is equivalent to the output of an ideal modulator with $\frac{\pi}{4}$ phase shift and a gain scaling factor of $\sqrt{2}$.

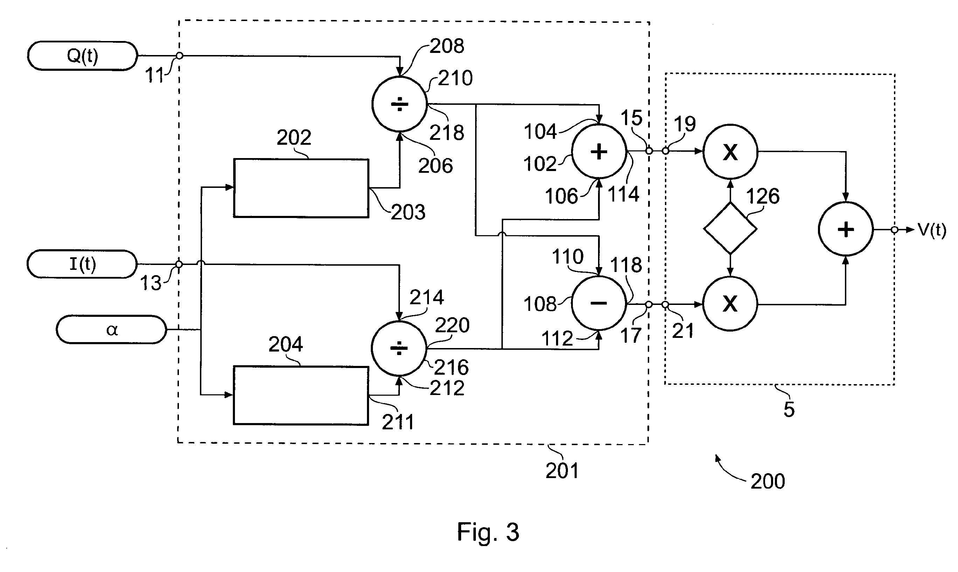

The operation of the modulating means 1 of the above preferred embodiment of the present invention can be further improved by scaling the incoming I and Q signals. An embodiment of an implementation of such a modulating means is shown in Figure 3. The elements which correspond to the same elements of Figures 1 and 2 have identical reference numerals.

The modulating means 200 is the same as the modulating means 1 shown in Figures 1 and 2 except that the pre-processor 201 further comprises a first scaling factor generating means 202 and a second scaling factor generating means 204. An output terminal 203 of the first scaling factor generating means 202 is connected to an input terminal 206 of a first divider 210. Another input terminal 208 of the first divider 210 is connected to the first input terminal 11 of the pre-processor 201 which receives the incoming $Q(t)$ baseband signal. An output terminal 211 of the second scaling factor generating means 204 is connected to an input terminal 212 of a second divider 216. Another input terminal 214 of the second divider 216 is connected to the second input terminal 13 of the pre-processor 201 which receives the incoming $I(t)$ baseband signal. An output terminal 218 of the first divider 210 is connected to the first input terminal 104 of the adder 102 and the first input terminal 110 of the subtractor 108. The output terminal 220 of the second divider 216 is connected to the second input terminal 112 of the subtractor 108 and the second input terminal 106 of the adder 102.

The first scaling factor generating means 202 calculates a first scaling factor of 2.sin($\alpha$/2). The second scaling factor generating means 204 calculates a second scaling factor of 2.cos($\alpha$/2).

This results in the signal input $Q(t)$ on the first input terminal 11 of the pre-processor 201 being scaled by the factor 2.sin ($\alpha/_2$) and the signal input $I(t)$ on the second input terminal 13 of the pre-processor 201 being scaled by the factor 2.cos($\alpha/_2$).

The incoming Q and I signals are first divided by a factor 2.sin ($\alpha/_2$) and 2.cos($\alpha/_2$) respectively, added and subtracted from each other to generate two outputs on the output terminals 15, 17 of the pre-processor 201 for input into the I and Q modulator 5 at input terminals 19, 21 of the modulators, namely:

$$\frac{Q(t)}{2.\sin(\alpha/2)} + \frac{I(t)}{2.\cos(\alpha/2)}$$

and

$$\frac{I(t)}{2.\cos(\alpha/2)} - \frac{Q(t)}{2.\sin(\alpha/2)},$$

respectively

These pre-processed outputs are then used as the inputs to the conventional modulator 5 in which the modulator is assumed to be non-ideal such that, as above, instead if expected sin and cos terms the local oscillator 126 has the characteristics of two sin terms separated by an angle $\alpha$, which in an ideal modulator would be 90°. This results in:

$$\left(\frac{Q(t)}{2.\sin(\alpha/2)} + \frac{I(t)}{2.\cos(\alpha/2)}\right).\sin(\omega.t + \alpha) + \left(\frac{I(t)}{2.\cos(\alpha/2)} - \frac{Q(t)}{2.\sin(\alpha/2)}\right).\sin(\omega.t)$$

grouping together I and Q elements:

$$\left(\frac{Q(t)}{2.\sin(\alpha/2)}\right).(\sin(\omega.t \; + \; \alpha) \; - \; \sin(\omega.t)) \; + \; \left(\frac{I(t)}{2.\cos(\alpha/2)}\right).(\sin(\omega.t \; + \; \alpha) \; + \; \sin(\omega.t))$$

Now using standard trig formulae for sin($a$) + sin($b$) and sin($a$) -sin($b$)

$$\left(\frac{Q(t)}{\sin(\alpha/2)}\right).\sin\left[\frac{(\omega.t+\alpha)-\omega.t}{2}\right].\cos\left[\frac{(\omega.t+\alpha)+\omega.t}{2}\right]+\left(\frac{I(t)}{\cos(\alpha/2)}\right).\sin\left[\frac{\omega.t+(\omega.t+\alpha)}{2}\right].\cos\left[\frac{\omega.t-(\omega.t+\alpha)}{2}\right]$$

or:

$$\left(\frac{Q(t)}{\sin(\alpha/2)}\right).\sin\left(\frac{\alpha}{2}\right).\cos\left(\omega.t \; + \; \frac{\alpha}{2}\right) \; + \; \left(\frac{I(t)}{\cos(\alpha/2)}\right).\cos\frac{\alpha}{2} \; .\sin\left(\omega.t \; + \; \frac{\alpha}{2}\right)$$

which results in:

$$Q(t).\cos\left(\omega.t \; + \; \frac{\alpha}{2}\right) \; + \; I(t).\sin\left(\omega.t \; + \; \frac{\alpha}{2}\right)$$

The result is that the modulator behaves as if the carrier is applied in perfect quadrature. Consequently, irrespective of the quadrature error of the local oscillator, in the apparatus of the present invention the error can be easily compensated for.

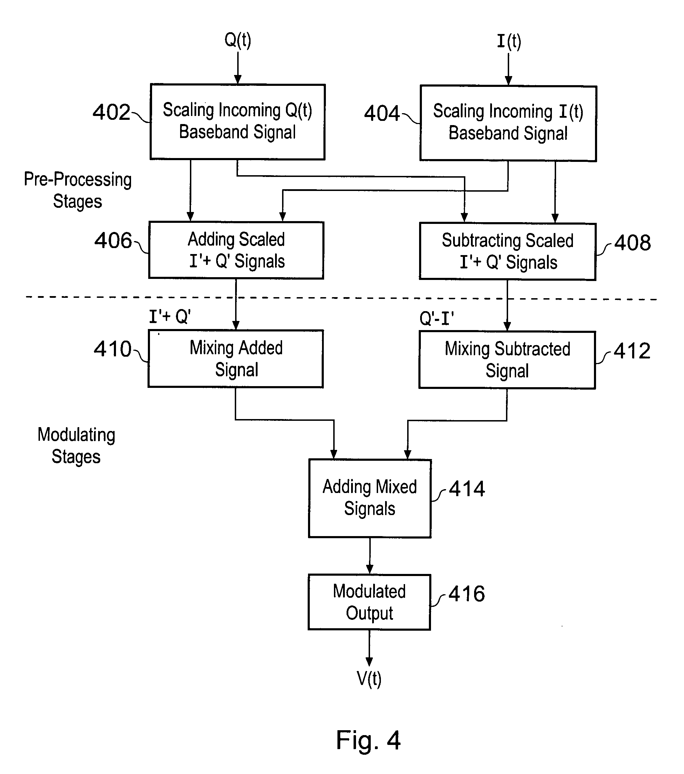

A method of the preferred embodiment of the present invention will now be described with reference to Figure 4. Incoming $Q(t)$ and $I(t)$ baseband signals are quadrature modulated to generated the modulated output $V(t)$. In the preferred embodiment the $Q(t)$ and $I(t)$ signals are pre-processed and then modulated. The pre-processing stages generate composite signals $I'(t) + Q'(t)$ and $Q'(t) - I'(t)$ These composite signals form the input of the modulating stages to generate the output V(t). The pre-processing stages effectively compensate for any phase shift error in the quadrature outputs of the local oscillator of the modulator in the modulating stages.

The pre-processing stages comprise the step 402 of scaling the incoming $Q(t)$ baseband signal and the concurrent step 404 of scaling the incoming $I(t)$ baseband signal. The scaling steps 402 and 404 may not be utilised in the method of the present invention. Amplitude control of the resulting modulated output $V(t)$ may be made by other means.

The scaled I'($t$) and Q'($t$) signals are then added at step 406 and subtracted at step 408. The resulting composite signals of the adding and subtracting steps 406 and 408 are then provided as the inputs to the modulating stages. The input composite signals $I'(t) + Q'(t)$ and $Q'(t) - I'(t)$ are mixed with respective quadrature outputs of a local oscillator, having a relative phase of $\alpha$ therebetween, at steps 410, 412. These mixed signals are added together at step 414 and the resulting modulated signal $V(t)$ is output at step 416. The pre-processing stages of adding and subtracting 406, 408 the incoming $Q(t)$ and $I(t)$ baseband signals and the preferred additional steps of scaling 402, 404 the incoming $Q(t)$ and $I(t)$ baseband signals effectively compensates for phase error in the quadrature outputs of the local oscillator of the quadrature modulator (used during the modulating stages) as illustrated above.

Although preferred embodiments of the method and apparatus of the present invention has been illustrated in the accompanying drawings and described in the forgoing detailed description, it will be understood that the invention is not limited to the embodiments disclosed, but is capable of numerous variations, modifications without departing from the scope of the invention as set out in the following claims.

**Claims**

1.  A method for compensating for phase error in a quadrature local oscillator of a quadrature modulator, the method comprising the steps of:

    generating a first scaling factor and a second scaling factor, the first scaling factor and the second scaling factor being derived from the phase error of the quadrature local oscillator used during quadrature modulation;
    scaling input I and Q signals by the first and second scaling factors, respectively;
    adding the scaled I and Q signals;
    subtracting the scaled I and Q signals; and
    quadrature modulating the added and subtracted signals.

2.  A method for modulating I and Q signals, the method comprising the steps of:

    generating a first and second scaling factor dependent on the phase error of the quadrature outputs of a local oscillator utilised during quadrature modulation;
    applying a first scaling factor to an input I signal;
    applying a second scaling factor to an input Q signal;
    adding the scaled I and Q signals;
    subtracting the scaled I and Q signals; and
    quadrature modulating the added and subtracted signals.

3.  A method according to claim 2 or 3, wherein the first scaling factor comprises $2.\cos(\alpha/2)$, wherein $\alpha$ is the relative phase of the quadrature outputs of the local oscillator utilised during quadrature modulation of the added and subtracted signals.

4.  A method according to anyone of claims 2 to 4 wherein the second scaling factor comprises $2\cdot\sin(\alpha/2)$, wherein $\alpha$ is the relative phase of the quadrature outputs of the local oscillator utilised during quadrature modulation of the added and subtracted signals.

5.  A quadrature modulator for modulating I and Q signals comprising:

    a first scaling means for scaling the input I signal by a first factor;
    a second scaling means for scaling the input Q signal by a second factor;
    adding means for adding the scaled I and Q signals;
    subtracting means for subtracting the scaled I and Q signals; and
    modulating means for quadrature modulating the added and subtracted signals, wherein the first and second scaling factors are dependent on the phase error of a local oscillator utilised during quadrature modulation of the added and subtracted signals.

6.  A quadrature modulator according to claim 6, wherein the first scaling factor is $2\cdot\cos(\alpha/2)$, wherein $\alpha$ is the relative phase of a local oscillator utilised during quadrature modulation of the added and subtracted signals.

7.  A quadrature modulator according to claim 6 or 7, wherein the second scaling factor is $2\cdot\sin(\alpha/2)$, wherein $\alpha$ is the relative phase of a local oscillator utilised during quadrature modulation of the added and subtracted signals.

8.  A quadrature modulator according to any one of claim 6 to 8, wherein the modulating means comprises:

    a local oscillator for generating quadrature local oscillator signals having a phase difference;
    a pair of mixers to combine the added and subtracted signals with respective quadrature local oscillator signals;
    adding means to add the outputs of the pair mixers.

9.  A mobile communications device including at least one quadrature modulator according to any one of claims 6 to 9.

Fig. 1

Fig. 2

Fig. 3

Fig. 4

**European Patent Office**

**EUROPEAN SEARCH REPORT**

Application Number

EP 02 25 8665

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| Y | US 5 111 155 A (KEATE CHRISTOPHER R ET AL) 5 May 1992 (1992-05-05) * abstract * * column 2, line 35 - line 67 * * column 5, line 45 - line 52 * * column 6, line 26 - line 36 * * figures 5,6A * | 1-9 | H04L27/36 H03C3/40 |
| Y | WO 01 63760 A (MOTOROLA INC) 30 August 2001 (2001-08-30) * abstract * * page 2, line 6 - line 28 * * page 3, line 4 - line 12 * * figure 2 * | 1-9 | |
| A | US 6 240 142 B1 (APARIN VLADIMIR ET AL) 29 May 2001 (2001-05-29) * abstract * * column 4, line 48 - column 5, line 6 * * column 5, line 65 - column 6, line 32 * * column 8, line 40 - line 43 * * figure 2 * | 1-9 | TECHNICAL FIELDS SEARCHED (Int.Cl.7) H04L H03C H03D |
| A | US 5 438 301 A (MONTGOMERY ROBERT K ET AL) 1 August 1995 (1995-08-01) * abstract * * column 1, line 49 - column 2, line 7 * | 1-9 | |

The present search report has been drawn up for all claims

| Place of search | Date of completion of the search | Examiner |
|---|---|---|
| MUNICH | 10 March 2003 | Baltersee, J |

## ANNEX TO THE EUROPEAN SEARCH REPORT
## ON EUROPEAN PATENT APPLICATION NO.

EP 02 25 8665

This annex lists the patent family members relating to the patent documents cited in the above-mentioned European search report.
The members are as contained in the European Patent Office EDP file on
The European Patent Office is in no way liable for these particulars which are merely given for the purpose of information.

10-03-2003

| Patent document cited in search report | | Publication date | Patent family member(s) | | Publication date |
|---|---|---|---|---|---|
| US 5111155 | A | 05-05-1992 | NONE | | |
| WO 0163760 | A | 30-08-2001 | US | 6222405 B1 | 24-04-2001 |
| | | | AU | 3668301 A | 03-09-2001 |
| | | | WO | 0163760 A1 | 30-08-2001 |
| US 6240142 | B1 | 29-05-2001 | AU | 2028299 A | 26-07-1999 |
| | | | BR | 9906790 A | 31-10-2000 |
| | | | CA | 2316969 A1 | 15-07-1999 |
| | | | CN | 1288607 T | 21-03-2001 |
| | | | EP | 1046223 A1 | 25-10-2000 |
| | | | JP | 2002501316 T | 15-01-2002 |
| | | | WO | 9935736 A1 | 15-07-1999 |
| US 5438301 | A | 01-08-1995 | EP | 0695067 A2 | 31-01-1996 |
| | | | JP | 8130442 A | 21-05-1996 |

EPO FORM P0459

For more details about this annex : see Official Journal of the European Patent Office, No. 12/82